# EUROPEAN PATENT APPLICATION

(11) **EP 3 285 120 A1**
(43) Date of publication of application: **21.02.2018**
(21) Application number: 16201944.2
(22) Date of filing: 02.12.2016
(51) Int. Cl.: G03F 7/20, G03F 9/00

(54) **STAGE LEVELING DEVICE FOR HIGH PERFORMANCE MASK ALIGNER**

(30) Priority: 16.08.2016 KR 20160103573
(71) Applicant: Midas System Co., Ltd., Daejeon 34029 (KR)
(72) Inventor: LEE, Gon Chul, 30052 Sejong-si (KR); MIN, Heung Ki, 34079 Yuseong-gu, Daejeon (KR); LEE, Jun Hyeong, 34167 Daejeon (KR); JEON, Jae Geun, 34384 Daedeok-gu, Daejeon (KR)
(74) Representative: Mittler, Enrico

(57) **Abstract**

Disclosed is a stage leveling device for a high-performance mask aligner, having enhanced leveling maintenance and, in particular, a novel technology of preventing leveling misalignment by firmly fixing a leveling-completed wafer stage.

A conventional leveling device fixes a leveling-completed wafer stage by partially pressing side surfaces of a leveling rod and thus the leveling is misaligned due to deviations (errors) occurring while the leveling rod is moved upward and downward and leftward and rightward, and slip occurs due to a weak fixing strength of the leveling rod and thus the weight of the wafer (sample) that can be leveled to the maximum extent is decreased.

To address the problems described above, according to the present invention, when a locking ring (80) inserted at an outer side of a leveling rod (40;41) maintains an inclined state, locking is performed such that an inner circumferential surface of the locking ring fixes opposite sides of the leveling rod by applying pressure thereto and, when the locking ring maintains a horizontal state, unlocking is performed such that the inner circumferential surface of the locking ring is spaced apart from the leveling rod.

## Description

### [Technical Field]

The present invention relates to a novel technology for preventing leveling misalignment by firmly fixing a leveling-completed wafer stage and improving performance by increasing a maximum capacity (weight) of a wafer to be leveled.

### [Background Art]

Recently, low cost and high performance highly integrated semiconductor devices have been required to secure market competitiveness. For high integration of semiconductor devices, scaling-down processes including a process of thinning and shortening gate oxide films and channels of transistor devices, and the like are involved and, accordingly, technologies and systems for manufacturing semiconductors are being developed into various types.

Photolithography, which is one semiconductor manufacturing process, includes: a wafer washing process of removing impurities from a surface of a wafer; a surface treatment process of surface-treating the wafer so that a photosensitive film is satisfactorily adhered to the wafer; a photosensitive film coating process of uniformly coating the photosensitive film on the wafer to a desired thickness; alignment and light exposure processes of aligning a mask or a reticle (hereinafter, referred to as a mask) on the wafer with the photosensitive film coated thereon and exposing the mask to light so as to form circuit patterns of the mask on the wafer; and a developing process of removing the photosensitive film deformed by light exposure using a washing solution. In particular, a core semiconductor device for the alignment/light exposure processes is called a mask aligner.

A general mask aligner includes a mask stage on which a mask with predetermined patterns is mounted, a wafer stage on which a wafer etched according to the patterns of the mask is mounted, and a projection optical system installed therebetween.

A mask with circuit patterns is mounted on the mask stage, a vacuum-sucked wafer is mounted on the wafer stage, and then a position to be exposed to light is selected by horizontal and vertical movements thereof.

As the related art, Patent Registration No. 1360954 (title of the invention: Stage Leveling Device for Mask Aligner having Improved Leveling Performance), which was previously registered by the applicant of the present application, is disclosed.

According to the above related art, leveling is performed by freely moving a wafer stage upward and downward using a plurality of leveling air shock absorbers, centering is maintained by supporting the center of the wafer stage at one point using a single centering module, and then the leveling is maintained such that a stage fixing cylinder fixes side surfaces of a leveling rod by applying pressure thereto.

### [Disclosure]

### [Technical Problem]

Even though such leveling is precisely performed, the wafer is no longer level when fine movement of a wafer stage occurs after completion of leveling.

According to the above related art, a leveling-completed wafer stage is fixed by partially pressing side surfaces of the leveling rod and thus the wafer stage is not level by deviations (errors) occurring while the leveling rod moves upward and downward and leftward and rightward, and slip occurs due to a weak fixing strength of the leveling rod and thus the weight of the wafer (sample) that can be leveled to the maximum extent is decreased.

In addition, a general air cylinder is used in the air shock absorber of the above related art and thus flexibility according to movement is reduced due to a high initial setting value and fine pressure adjustment is also difficult.

In addition, centering performance of the centering module for one-point supporting the center of the wafer stage varies according to processing and assembly degrees and thus a high level of skill and ultraprecision are required in manufacturing processes and, when such requirements are not satisfied, the centering process is not accurately performed.

### [Technical Solution]

In accordance with one aspect of the present invention, provided is a technology for performing locking such that, when a locking ring inserted at an outer side of a leveling rod maintains an inclined state, an inner circumferential surface of the locking ring fixes opposite sides of the leveling rod by applying pressure thereto and for performing unlocking such that, when the locking ring maintains a horizontal state, the inner circumferential surface of the locking ring is spaced apart from the leveling rod.

In accordance with another aspect of the present invention, provided is a technology characterized in that, in a process of performing leveling of a wafer in a state in which a locking ring is unlocked by moving a locking control cylinder forward, the locking ring may lock a leveling rod by receiving feedback of a pressure value of a leveling air shock absorber including a low friction cylinder and moving the locking control cylinder backward at an accurate time at which leveling has been completed, based on the pressure value.

In accordance with another aspect of the present invention, provided is a technology characterized in that three centering modules installed at a circumference of a wafer stage may precisely maintain centering by supporting an outer circumferential surface of the wafer stage at three points.

### [Advantageous effects]

As apparent from the fore-going description, an inner circumferential surface of a locking ring inserted at an outer side of a leveling rod fixes opposite sides of the leveling rod by apply pressure thereto and a leveling air shock absorber is locked without movement of the leveling rod, thereby fixing a wafer stage and thus, during light exposure, precise leveling is maintained and working quality is significantly improved, and an effect of significantly improving performance of a leveling device is obtained by increasing a maximum capacity (weight) of a wafer to be leveled, by enhancing a fixing power of the wafer stage.

In addition, opposite sides of the leveling rod are fixed at a constant pressure and thus leftward and rightward movements of the leveling rod are prevented and tilt, twist or torsion of the leveling rod is also prevented and, accordingly, the leveling rod has significantly enhanced durability.

In addition, a low friction cylinder is applied to the leveling air shock absorber that performs leveling and thus fine pressure adjustment and contact force control are possible and, in a process of performing leveling of a wafer using a pressure sensor installed at the leveling air shock absorber, locking is performed by moving a locking control cylinder at an accurate time at which leveling has been completed, by controlling locking of the leveling air shock absorber by receiving feedback of a pressure value.

In addition, three centering modules installed at a circumference of the wafer stage maintain centering in a way of supporting an outer circumferential surface of the wafer stage at three points and thus errors according to processing and assembly degrees of the centering modules barely occur and, accordingly, a high level of skill and accuracy are not required in manufacturing of the centering modules, which enables easy fabrication, reduced manufacturing costs, and very accurate centering performance.

### [Description of Drawings]

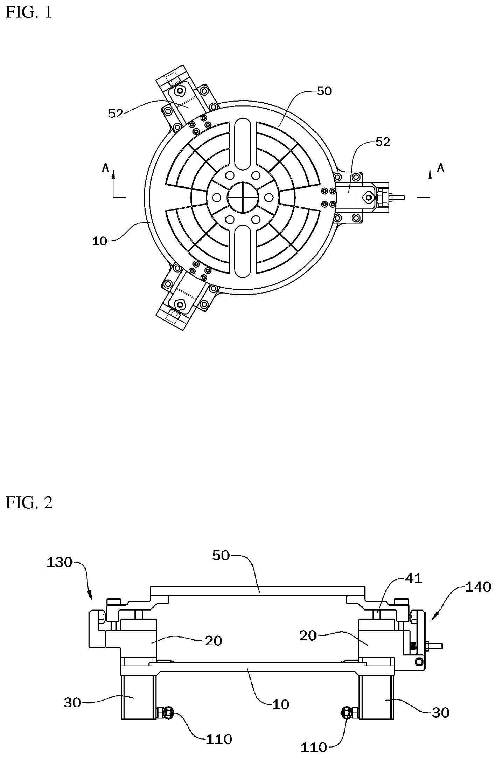

FIG. 1 is a plan view of a stage leveling device according to an embodiment.
FIG. 2 is a front view of the stage leveling device.

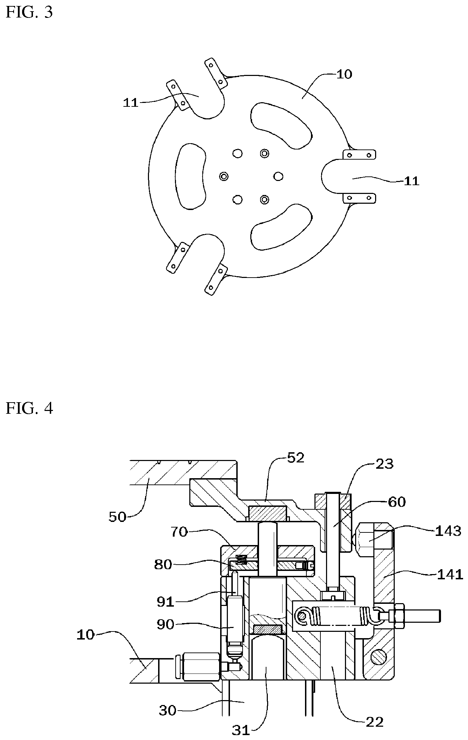

FIG. 3 is a plan view of a base plate, according to an embodiment.
FIG. 4 is a partial enlarged cross-sectional view taken along line A-A of FIG. 1.
FIG. 5 is a front cross-sectional view illustrating installation states of a leveling rod, a ring housing, a locking ring, and a locking control cylinder, according to an embodiment.
FIG. 6 is a plan cross-sectional view illustrating installation states of the leveling rod, the ring housing, and the locking ring.
FIG. 7 illustrates plan and front cross-sectional views of the locking ring.
FIG. 8 is a front cross-sectional view illustrating a state in which the locking ring is unlocked.
FIG. 9 is a front cross-sectional view illustrating the locking ring in a locked state.
FIG. 10 is a front cross-sectional view illustrating an installation state of a stopper, according to an embodiment.
FIG. 11 is a front view of a centering module provided with a fixing centering bar, according to an embodiment.
FIG. 12 is a front cross-sectional view of a centering module provided with a rotary centering bar, according to an embodiment.
FIG. 13 is a plan cross-sectional view of the centering module provided with a rotary centering bar.

### [Best mode]

Exemplary embodiments of the present invention will now be described in more detail to implement the technical solutions.

The entire configuration according to an exemplary embodiment of the present invention will be schematically described according to the accompanying drawings. Referring to the drawings, a plurality of guide blocks 20, a plurality of leveling air shock absorbers 30, a plurality of leveling rods 40, a wafer stage 50, a plurality of guide bolts 60, a ring housing 70, a locking ring 80, and a locking control cylinder 90 are included as elements of the present invention.

Hereinafter, the schematic configuration of the present invention will be described in further detail in such a way that the invention may be easily carried out.

A base plate 10 is movably installed upward and downward by a known vertical moving device and is provided, on an upper end thereof, with a plurality of guide blocks 20 spaced apart from each other by an interval of 120° in a circumferential direction, and the guide block 20 is provided, at the center thereof, with a rod guide hole 21 penetrating upward and downward to guide the leveling rod 40 upward and downward.

A plurality of leveling air shock absorbers 30 is attached to a bottom surface of the base plate 10 to correspond to the guide blocks 20, and a piston rod 31 of each leveling air shock absorber 30 passes through a rod path 11 formed in the base plate 10 and is inserted through a lower side of the rod guide hole 21.

The leveling air shock absorber 30 includes a low friction cylinder that smoothly operates even at a low pressure due to the design of a piston having a low sliding resistance, instead of a general air cylinder, and, accordingly, the leveling air shock absorber 30 has fine pressure adjustment and contact force control effects.

The leveling rod 40 mounted on an upper end of the piston rod 31 is inserted through an upper portion of the rod guide hole 21, and a ground pin 41 protruding from an upper portion of the leveling rod 40 is exposed to the outside so that a wafer stage 50 is mounted on upper ends of the ground pins 41.

In this regard, a magnet 42 is embedded below the leveling rod 40 and the piston rod 31 of the leveling air shock absorber 30 is closely grounded by a magnetic force of the magnet 42 and, accordingly, the leveling rod 40 and the piston rod 31 mutually move in an integrated form, whereby leveling performance is significantly improved.

In the guide bolts 60 inserted into bolt insertion grooves 22 formed at bottom surfaces of the guide blocks 20, a lower side of each guide bolt 60 penetrates an upper portion of the guide block 20 and is screw-coupled in an integrated manner and an upper side thereof penetrates upper and lower portions of the wafer stage 50 and is screw-coupled with a nut 23 on the upper side. Accordingly, the wafer stage 50 and the guide blocks 20 maintain an integrated form without separation and the guide blocks 20 may smoothly guide downward movement of the wafer stage 50 when leveling is performed.

Thus, even though impact is transferred to the wafer stage 50, the leveling air shock absorber 20 acts as a buffer smoothly absorbing impact. In particular, in the present invention, leveling air shock absorbers 30 are installed at three points and thus may smoothly perform leveling by most stably supporting the wafer stage 50 at three points.

The wafer stage 50 may be directly seated on the upper ends of the leveling rods 40. In this case, to prevent the size of the wafer stage 50 from increasing more than as required, the wafer stage 50 is provided, at a bottom surface thereof, with a plurality of supports 52 protruding to the outside, the supports 52 are mounted on the upper ends of the leveling rods 40, and the guide bolts 60 may be screw-coupled with the nuts 23 closely contacting upper surfaces of the supports 52, in a state of being penetratively coupled with upper and lower portions of the supports 52.

In addition, after the leveling process is completed, the leveling air shock absorbers 30 are locked by simultaneously fixing opposite sides of the leveling rods 40 by applying pressure thereto, thereby fixing the wafer stage 50 without movement, which is a core technology of the present invention.

To achieve such configuration, the ring housing 70 with an opening at a bottom portion thereof is fixedly installed on an upper end of the guide block 20, and the piston rod 31 of the leveling air shock absorber 30 penetrates the ring housing 70 to be exposed to the outside.

The locking ring 80 in a state of penetrating the piston rod 31 is inserted inside the ring housing 70, and a rotatory support sphere 81 formed at one side of the locking ring 80 is supported by and inserted into a support hole 71 formed at an inner circumferential surface of the ring housing 70 and, accordingly, the locking ring 80 may rotate upward and downward about the rotatory support sphere 81.

In this regard, the locking ring 80 has a disk shape and is provided with a coupling protrusion 82 at one side thereof, and the rotatory support spheres 81 respectively supported by and inserted into the support holes 71 formed in an inner surface of the ring housing 70 are screw-coupled in an integrated form with intervals therebetween at the coupling protrusion 82. In addition, a portion of the rotatory support sphere 81 which is inserted into the support hole 71 has a spherical shape and thus a contact area between the rotatory support sphere 81 and the support hole 71 is small and, accordingly, friction therebetween is decreased during rotation, thereby enabling smooth operation.

The guide block 20 is provided, at an upper end thereof, with a cylinder groove 24 recessed adjacent to the rod guide hole 21, the locking control cylinder 90 for selectively controlling locking/unlocking of the locking ring 80 is inserted into the cylinder groove 24, and a piston rod 91 disposed at the locking control cylinder 90 is exposed to the outside and grounded to a bottom surface of the locking ring 80 so that the locking ring 80 can rotate upward and downward about the rotatory support sphere 81 according to an upward or downward linear movement of the locking control cylinder 90.

According to the present invention, a leveling process of maintaining a degree of parallelization with high accuracy between a mask and a wafer mounted on a wafer chuck of the wafer stage 50 is performed and then a leveling process for preventing the degree of parallelization between the mask and the wafer from being decreased by temporarily fixing the leveling rod 40 that has supported the wafer stage 50 so as to freely move upward and downward may be maintained.

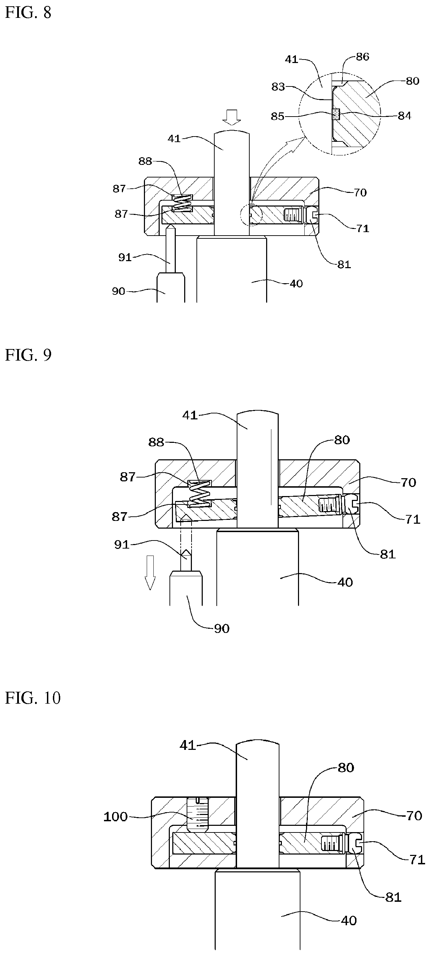

In this regard, as illustrated in FIG. 8, the locking ring 80 maintains a horizontal state when the leveling process is performed and thus a gap is formed between an inner circumferential surface 83 of the locking ring 80 and an outer circumferential surface of the leveling rod 40 and, accordingly, the leveling rod 40 freely moves upward and downward, which enables normal leveling and, after the leveling process is completed, the leveling rod 40 is fixed by applying pressure thereto.

In detail, as illustrated in FIG. 9, the leveling rod 40 is fixed such that, when the locking control cylinder 90 is moved backward, the locking ring 80 maintains an inclined state while rotating downward about the rotatory support sphere 81 and opposite sides of the inner circumferential surface 83 of the locking ring 80 fixes opposite sides of the outer circumferential surface of the leveling rod 40 by applying pressure thereto, thereby maintaining locking.

Thus, the locking ring 80 fixes the opposite sides of the outer circumferential surface of the leveling rod 40 by applying pressure thereto and fixes the wafer stage at the same time without fine movement, tilt, and torsion of the locking rod 40 and, accordingly, precise leveling is maintained and working quality is significantly improved, during light exposure.

In addition, the fixed state of the leveling rod 40 may be unlocked such that, when the locking control cylinder 90 is moved forward, the locking ring maintains its position in a horizontal state while rotating upward about the rotatory support sphere 81 and the inner circumferential surface 83 of the locking ring 80 is spaced apart from the outer circumferential surface of the leveling rod 40 to thus form a gap therebetween, thereby automatically performing unlocking.

The locking ring 80 is provided with a ring groove 84 recessed in the center of the inner circumferential surface 83 thereof, and a compression ring 85 inserted into the ring groove 84 further compression-fixes the outer circumferential surface of the leveling rod 40 and, accordingly, the fixing power of the locking ring 80 may be significantly enhanced. In addition, an interference preventing part 86 is recessed in each of upper and lower edge portions of the inner circumferential surface 83 and thus, when the locking ring 80 maintains an inclined state, an interference phenomenon, in which the edge portions are stuck by the outer circumferential surface of the leveling rod 40, may be effectively prevented by the interference preventing parts 86.

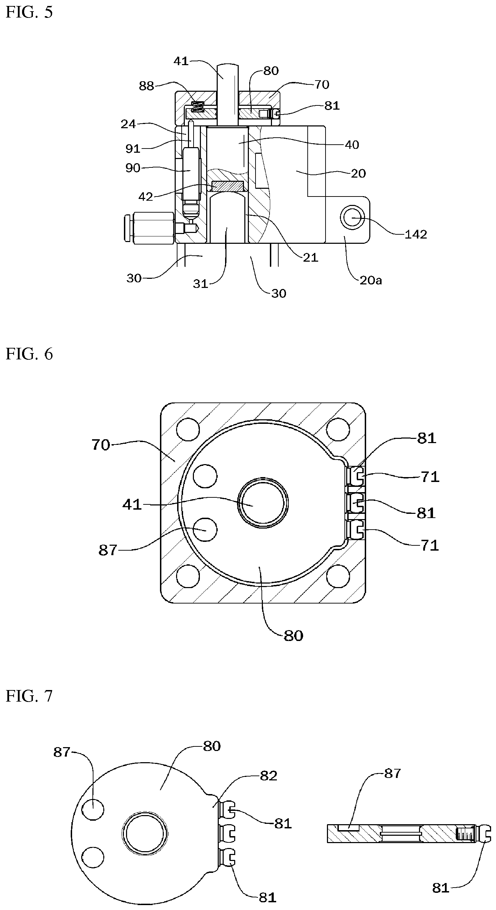

In addition, as illustrated in FIGS. 7 and 8, the locking ring 80 is provided with a spring support groove 87 recessed in an upper surface of one side thereof, and the spring support groove 87 is recessed in an inner surface of an upper side of the ring housing 70 to correspond to the spring support groove 87 of the locking ring 80. A spring 88 is supported by and inserted into the spring support grooves 87 so as to elastically bias the locking ring 80 downward and thus, when the piston rod 91 of the locking control cylinder 90 is moved backward in a downward direction, the spring 88 applies elasticity, thereby further facilitating a downward rotation of the locking ring 80.

In addition, when the locking ring 80 rotates upward, as illustrated in FIG. 10, a stopper 100 is screw-coupled to be exposed to the inside at one side of the ring housing 70 so as to prevent the locking ring 80 from escaping from the horizontal state due to excessive rotation. In addition, the stopper 100 restricts excessive rotation of the locking ring 80 that rotates upward, thereby enabling the locking ring 80 to perform unlocking while maintaining an accurate horizontal state.

In addition, in the leveling process, the locking of the locking ring 80 may be controlled at a more accurate time by receiving feedback of a pressure applied to the leveling rod 40.

For this configuration, when the locking control cylinder 90 is moved forward, the locking ring 80 unlocks the leveling rod 40, thereby performing normal leveling of a wafer. In this process, a programmable logic controller (PLC) receives feedback of a pressure applied to the leveling rod 40 via a pressure sensor 110 installed at the leveling air shock absorber 30 and compares the feedback with a set pressure value. As a result of determination, the PLC controls the locking ring 80 to lock the leveling rod 40 while moving the locking control cylinder 90 backward and thus locking of the locking ring 80 is rapidly performed at an accurate time at which leveling of the wafer is completed, whereby leveling maintenance may be enhanced.

In addition, configuration of three centering modules 130 and 140 is further applied to the present invention. In this regard, the outer circumferential surface of the wafer stage 50 is supported at three points by three centering modules 130 and 140 installed at a circumference of the wafer stage 50 and also centering may be more accurately maintained.

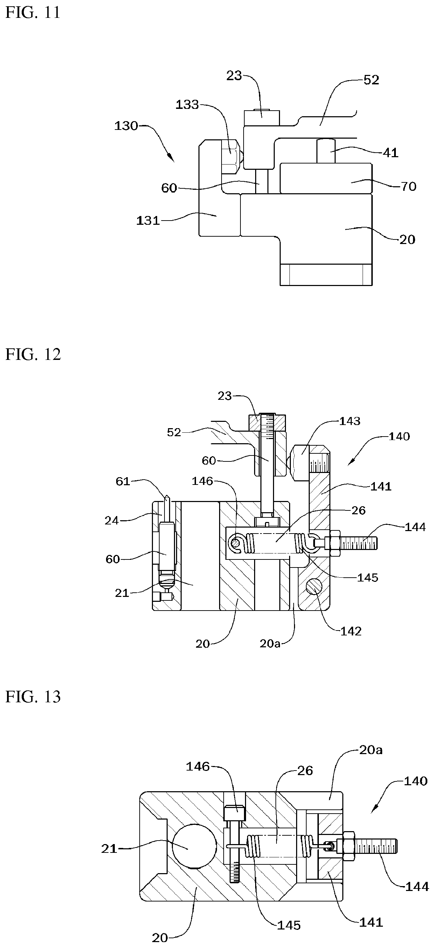

Each of the three centering modules 130 and 140 is positioned at the guide block 20 to maintain centering of the wafer stage 50. As illustrated in FIG. 11, the two centering modules 130 of the three centering modules 130 and 140 perform two-point support in a state in which a fixing centering bar 131 is attached in an integrated manner to an outer surface of the guide block 20, and a ball plunger 133 coupled to an upper portion of the fixing centering bar 131 closely contacts an outer surface of the support 52. In addition, the two centering modules 130 maintain a fixed state at all times to provide a base point for centering.

In addition, as for the remaining centering module 140 of the three centering modules 130 and 140, as illustrated in FIGS. 12 and 13, a lower side of a rotatory centering bar 141, through which a connection pin 142 penetrates, is rotatably installed at a connection bracket 20a protruding from the outer surface of the guide block 20, a ball plunger 143 coupled to an upper portion of the rotatory centering bar 141 closely supports the outer surface of the support 52, a spring support bolt 144 penetrating the rotatory centering bar 141 is connected to one side of a tensile spring 145 inserted into a spring inserting part 26 disposed in the guide block 20, and the other side of the tensile spring 145 is connected to a spring fixing part 146 penetrating the spring inserting part 26 in a perpendicular state and screw-coupled with the guide block 20.

Thus, the rotatory centering bar 141 is supported by and presses the wafer stage 50 towards the two fixing centering bars 131 that provide a base point by a tensile force of the tensile spring 145 and, accordingly, accurate centering may be more precisely maintained at all times.

**[DESCRIPTION OF REFERENCE NUMERALS]**

| | |
|---|---|
| 10: BASE PLATE | 20: GUIDE BLOCK |
| 21: GUIDE HOLE | 30: LEVELING AIR SHOCK |
| ABSORBER | |
| 31, 91: PISTON ROD | 40: LEVELING ROD |
| 41: GROUND PIN | 50: WAFER STAGE |
| 52: SUPPORT | 60: GUIDE BOLT |
| 70: RING HOUSING | 71: SUPPORT HOLE |
| 80: LOCKING RING SPHERE | 81: ROTATORY SUPPORT |
| 82: COUPLING PROTRUSION CIRCUMFERENTIAL SURFACE | 83: INNER |
| 85: COMPRESSION RING PREVENTING PART | 86: INTERFERENCE |
| 87: SPRING SUPPORT GROOVE | 88: SPRING |
| 90: LOCKING CONTROL CYLINDER | 100: STOPPER |
| 110: PRESSURE SENSOR MODULE | 130,140: CENTERING |
| 131: FIXING CENTERING BAR | 133,143: BALL PLUNGER |
| 141: ROTATORY CENTERING BAR BOLT | 144: SPRING SUPPORT |
| 145: TENSILE SPRING SPHERE | 146: SPRING FIXING |

## Claims

1. A stage leveling device for a high-performance mask aligner, having enhanced leveling maintenance, the stage leveling device comprising:
a plurality of guide blocks (20) spaced apart from each other on an upper end of a base plate (10) and each provided, at a center thereof, with a rod guide hole (21) penetrating upward and downward;
a plurality of leveling air shock absorbers (30) attached to a bottom surface of the base plate (10) and each comprising a piston rod (31) penetrating the base plate (10) and inserted into a rod guide hole (21);
a plurality of leveling rods (40) each inserted into the rod guide hole (21) to be mounted on an upper end of the piston rod (31) and each comprising a ground pin (41) at an upper portion thereof to be exposed to the outside;
a wafer stage (50) mounted on upper ends of the leveling rods (40);
a plurality of guide bolts (60) each having a lower side coupled to the guide block (20) in an integrated manner and an upper side penetratively coupled to upper and lower portions of the wafer stage (50);
a ring housing (70) fixedly installed on an upper end of the guide block (20) in a state of being penetrated by the piston rod 31 of the leveling air shock absorber (30);
a locking ring (80) inserted into the ring housing (70) in a state of being penetrated by the piston rod (31) and provided, at one side thereof, with a rotatory support sphere (81) supported by and inserted into a support hole (71) formed in an inner circumferential surface of the ring housing (70); and
a locking control cylinder (90) inserted into a cylinder groove 24 recessed in an upper end of the guide block (20) and provided, at an upper portion thereof, with a piston rod (91) grounded to a bottom surface of the locking ring (80).

2. The stage leveling device for a high-performance mask aligner, having enhanced leveling maintenance, the stage leveling device comprising:
a plurality of guide blocks (20) spaced apart from each other on an upper end of a base plate (10) and each provided, at a center thereof, with a rod guide hole (21) penetrating upward and downward;
a plurality of leveling air shock absorbers (30) attached to a bottom surface of the base plate (10) and each comprising a piston rod (31) penetrating the base plate (10) and inserted into a rod guide hole (21);
a plurality of leveling rods (40) each inserted into the rod guide hole (21) to be mounted on an upper end of the piston rod (31) and each comprising a ground pin (41) at an upper portion thereof to be exposed to the outside;
a wafer stage (50) provided with a plurality of supports (52) attached to a bottom surface thereof to be positioned on upper ends of the leveling rods (40);
a plurality of guide bolts (60) each having a lower side coupled to the guide block (20) in an integrated manner and an upper side penetratively coupled to upper and lower portions of each support (52);
a ring housing (70) fixedly installed on an upper end of the guide block (20) in a state of being penetrated by the piston rod (31) of the leveling air shock absorber (30);
a locking ring (80) inserted into the ring housing (70) in a state of being penetrated by the piston rod (31) and provided, at one side thereof, with a rotatory support sphere (81) is supported by and inserted into a support hole (71) formed in an inner circumferential surface of the ring housing (70); and
a locking control cylinder (90) inserted into a cylinder groove (24) recessed in an upper end of the guide block (20) and provided, at an upper portion thereof, with a piston rod 91 grounded to a bottom surface of the locking ring (80).

3. The stage leveling device of claim 1, wherein the leveling air shock absorber (30) comprises a low friction cylinder.

4. The stage leveling device of claim 1, wherein, when the locking control cylinder (90) is moved backward, locking is performed such that the locking ring (80) maintains an inclined state while rotating downward about the rotatory support sphere (81) and opposite sides of an inner circumferential surface 83 of the locking ring (80) fixes opposite sides of an outer circumferential surface of the leveling rod (40) by applying pressure thereto, whereas, when the locking control cylinder (90) is moved forward, unlocking is performed such that the locking ring (80) maintains a horizontal state while rotating upward about the rotatory support sphere (81) and the inner circumferential surface (83) of the locking ring (80) is spaced apart from the outer circumferential surface of the leveling rod (40).

5. The stage leveling device of claim 1, wherein the locking ring (80) is provided with a compression ring (85) inserted into a ring groove (84) formed in a center of the inner circumferential surface (83), and an interference preventing part (86) is recessed in each of upper and lower edge portions of the inner circumferential surface (83).

6. The stage leveling device of claim 1, wherein the rotatory support spheres (81) are screw-coupled in an integrated form with intervals therebetween at a coupling protrusion (82) formed at one side of the locking ring (80), and a portion thereof inserted into the support hole (71) has a spherical shape.

7. The stage leveling device of claim 1, wherein the locking ring is provided with a spring support groove (87) recessed in an upper surface of one side thereof, the ring housing (70) is provided with the spring support groove (87) recessed in an inner surface of an upper side thereof, and the spring support grooves (87) are provided with a spring (88) supported thereby and inserted thereinto to elastically bias the locking ring (80) downward.

8. The stage leveling device of claim 1, wherein the ring housing (70) is provided, on one side thereof, with a stopper (100) screw-coupled to be exposed to the inside, wherein the stopper (100) restricts excessive rotation so that the locking ring (80) maintains a horizontal state while the locking ring (80) rotates upward.

9. The stage leveling device of claim 1, wherein, when the locking control cylinder (90) is moved forward, the locking ring (80) unlocks the leveling rod (40) to perform normal leveling of a wafer and, in this process, a programmable logic controller (PLC) receives feedback of a pressure applied to the leveling rod (40) via a pressure sensor (110) installed at the leveling air shock absorber (30) and compares the pressure with a set pressure value and, as a result of determination, the PLC controls the locking ring (80) to lock the leveling rod (40) while moving the locking control cylinder (90) backward at a time at which the leveling is completed.

10. The stage leveling device of claim 2, wherein the guide blocks (20) comprise three centering modules (130) and (140) to maintain centering of the wafer stage (50),
wherein two centering modules (130) of the three centering modules (130) and (140) are configured such that a fixing centering bar (131) is attached in an integrated manner to an outer surface of the guide block (20), and a ball plunger (133) coupled to an upper portion of the fixing centering bar (131) closely contacts an outer surface of the support (52), and
the one centering module (140) of the three centering modules (130) and (140) is configured such that a lower side of a rotatory centering bar (141), through which an connection pin (142) penetrates, is rotatably installed at an outer surface of the guide block (20), a ball plunger (143) coupled to an upper portion of the rotatory centering bar (141) closely supports the outer surface of the support (52), a spring support bolt (144) penetrating the rotatory centering bar (141) is connected to one side of a tensile spring (145), and the other side of the tensile spring (145) is connected to a spring fixing part (146) in a state of being inserted into a spring inserting part (26) formed in the guide block (20).
